# EUROPÄISCHE PATENTSCHRIFT

(11) **EP 2 689 976 B1**
(45) Veröffentlichungstag und Bekanntmachung des Hinweises auf die Patenterteilung: **23.05.2018**
(21) Anmeldenummer: 13173812.2
(22) Anmeldetag: 26.06.2013
(51) Int. Cl.: B60R 25/20, H03K 17/955, E05F 15/00

(54) **VERFAHREN ZUR ANSTEUERUNG EINER VERSCHLUSSELEMENTANORDNUNG INSBESONDERE EINES KRAFTFAHRZEUGS**
METHOD FOR CONTROLLING A CLOSURE ELEMENT, IN PARTICULAR OF A MOTOR VEHICLE
PROCÉDÉ DE COMMANDE D'UN ÉLÉMENT DE FERMETURE NOTAMMENT POUR VÉHICULE AUTOMOBILE

(30) Priorität: 25.07.2012 DE 102012014676
(43) Veröffentlichungstag der Anmeldung: 29.01.2014
(60) Teilanmeldung: 18161950.3
(73) Patentinhaber: Brose Fahrzeugteile GmbH & Co. Kommanditgesellschaft, Bamberg, 96052 Bamberg (DE)
(72) Erfinder: Holzberg, Frank, 97486 Königsberg (DE); Geuther, Udo, 96049 Bamberg (DE)
(74) Vertreter: Gottschald, Jan

(56) Entgegenhaltungen:
- EP-B1- 2 285 629
- WO-A1-2012/052210
- WO-A1-2013/034252
- FR-A1- 2 943 190
- US-A1- 2002 030 666

## Beschreibung

Die Erfindung betrifft ein Verfahren zur Ansteuerung einer Verschlusselementanordnung eines Kraftfahrzeugs gemäß dem Oberbegriff von Anspruch 1.

Bei heutigen Kraftfahrzeugen haben sich motorisch betätigbare Verschlusselemente mittlerweile durchgesetzt. Bei solchen Verschlusselementen kann es sich beispielsweise um Türen, wie Seiten- und Hecktüren, insbesondere Schiebetüren, Klappen, insbesondere Heckklappen, Heckdeckel, Motorhauben, Laderaumböden oder dgl. eines Kraftfahrzeugs handeln. Insoweit ist der Begriff "Verschlusselement" vorliegend weit zu verstehen.

Das Auslösen der motorischen Betätigung des Verschlusselements lässt sich bei dem bekannten Verfahren (DE 10 2010 055 297 A1, WO2012/052210 A1), von dem die Erfindung ausgeht, besonders komfortabel durch eine Fußbewegung des Benutzers bewerkstelligen. Hierfür ist ein Steuersystem mit einer Steuerung und einer Sensoranordnung vorgesehen, die zwei längliche, kapazitive Abstandssensoren aufweist. Mittels der Steuerung werden die Sensormesswerte der beiden Abstandssensoren daraufhin überwacht, ob der Benutzer eine vorbestimmte Fußbewegung durchgeführt hat. Bei der Erfassung eines solchen Bedienereignisses wird eine entsprechende Ansteuerung der Antriebsanordnung vorgenommen, hier die zugeordnete Heckklappe oder dgl. motorisch geöffnet oder geschlossen.

Die Zuverlässigkeit der Bedienereignisüberwachung stellt bei der Umsetzung des bekannten Verfahrens eine Herausforderung dar. Ein Grund hierfür besteht darin, dass die hier zur Anwendung kommenden, kapazitiven Abstandssensoren nur dafür ausgelegt sind, den Abstand zum Benutzer quer zur Sensorerstreckung zu erfassen. Das kann dazu führen, dass ein Vorbeilaufen des Benutzers entlang der Sensorerstreckung, das gegebenenfalls auch mit einer Annäherung des Benutzers an den Abstandssensor verbunden ist, fälschlicherweise als Bedienereignis erfasst werden kann. Der Steuerung liegen ja keine Informationen darüber vor, ob eine Bewegung des Benutzers entlang der Sensorerstreckung vorliegt.

Die Position des Benutzers entlang der Sensorerstreckung wird im Folgenden als "Längsposition" bezeichnet. Dies bedeutet, dass sich der Benutzer auf irgendeiner Bahnkurve befindet, die parallel zur Sensorerstreckung verläuft. In jeder Längsposition kann der Benutzer einen beliebigen Abstand zu dem Abstandssensor einnehmen. Es darf schon jetzt darauf hingewiesen werden, dass es sich bei der Sensorerstreckung nicht notwendigerweise um eine gerade Linie handelt. Vielmehr kann die Sensorerstreckung auf beliebigen Kurven liegen, also auch gekrümmt sein.

Die Umsetzung des bekannten Verfahrens stellt außerdem eine Herausforderung dar, weil heutige Kraftfahrzeuge mit einer Vielzahl von Anbaukomponenten, insbesondere mit Anhängerkupplungen, Fahrradträgern oder dgl. ausgestattet werden können, die eine sensorische Erfassung von Bedienereignissen stören. Beispielsweise ist eine Bedienereignisüberwachung mit dem bekannten Verfahren kaum möglich, sofern sich der Benutzer in einer Längsposition befindet, in der auch die Anhängerkupplung montiert worden ist.

Der Erfindung liegt das Problem zugrunde, das bekannte Verfahren derart auszugestalten und weiterzubilden, dass die Zuverlässigkeit der Bedienereignisüberwachung mit einfachen Mitteln gesteigert wird.

Das obige Problem wird bei einem Verfahren gemäß dem Oberbegriff von Anspruch 1 durch die Merkmale des kennzeichnenden Teils von Anspruch 1 gelöst.

Eine Überlegung besteht darin, den für die Bedienereignisüberwachung ohnehin vorgesehenen, mindestens einen Abstandssensor für die Ermittlung der Längsposition des Benutzers zu nutzen. Mit der so gewonnenen Information über die Längsposition des Benutzers kann beispielsweise Aufschluss darüber gewonnen werden, ob der Benutzer lediglich am Abstandssensor vorbeiläuft oder ob der Benutzer ein Bedienereignis vollzieht. Ferner ist es mit der vorschlagsgemäßen Lösung möglich, ein zu überwachendes Bedienereignis zu definieren, das eine Längsbewegung des Benutzers entlang der Sensorerstreckung umfasst.

Bei geeigneter Auslegung kann sich bei einer Längsbewegung des Benutzers entlang der Sensorerstreckung ein charakteristischer zeitlicher Verlauf der Sensormesswerte der Sensorstränge ergeben, der beispielsweise wiederum Bestandteil eines zu überwachenden Bedienereignisses sein kann.

Es darf darauf hingewiesen werden, dass der Begriff "Längsposition" nicht notwendigerweise die absolute Längsposition des Benutzers betrifft. Vielmehr ist der Begriff "Längsposition" vorliegend weit zu verstehen. Er umfasst alle Angaben, die einen Wert für die Längsposition des Benutzers bereitstellen. Entsprechendes gilt für das Verständnis des Begriffs "Abstand".

Vorzugsweise wird zur Ermittlung der Längsposition des Benutzers zunächst vorgeschlagen, dass mindestens zwei längliche, im Wesentlichen nebeneinander verlaufende Sensorstränge des mindestens einen Abstandssensors vorgesehen sind, die jeweils für sich auf die Erfassung eines Abstands zu einem Benutzer ausgelegt sind.

Weiter vorzugsweise weisen die Sensorstränge entlang der Sensorerstreckung sich verändernde Sensorkonfigurationen auf, und zwar so, dass mittels der Steuerung die Längsposition des Benutzers als Funktion aus den Sensormesswerten der mindestens zwei Sensorstränge ermittelt werden kann. Dies bedeutet, dass bei einem in einer Längsposition befindlichen Benutzer von einem Messwertpaar zweier Sensorstränge auf die Längsposition des Benutzers geschlossen werden kann. Vorzugsweise handelt es sich hier um eine ein-eindeutige Zuordnung zwischen Messwertpaar und Längsposition. Diese ein-eindeutige Zuordnung ist in manchen Anwendungsfällen aber nicht unbedingt erforderlich.

Es wird vorgeschlagen, dass mittels der Steuerung die Längsposition des Benutzers ermittelt wird und dass die Bedienereignisüberwachung in Abhängigkeit von der Längsposition des Benutzers modifiziert wird.

Wesentlich nach der vorschlagsgemäßen Lehre ist die Tatsache, dass die Bedienereignisüberwachung in Abhängigkeit von der Längsposition des Benutzers unterschiedlich vorgenommen wird. Beispielsweise kann damit erreicht werden, dass die Bedienereignisüberwachung für den Fall, dass sich der Benutzer in der gleichen Längsposition befindet wie eine montierte Anhängerkupplung, auf genau dieses Szenario angepasst wird. Bewegt sich nun der Benutzer in eine Längsposition, an der sich kein Anbauteil befindet, kann die Bedienereignisüberwachung beispielweise auf eine Standardüberwachung zurückgesetzt werden.

Mit der vorschlagsgemäßen Lehre lässt sich die Zuverlässigkeit bei der Bedienereignisüberwachung ebenfalls steigern, wobei für die Ermittlung der Längsposition ein beliebiges Verfahren Anwendung finden kann.

Im einfachsten Fall lässt sich die Ermittlung der Längsposition des Benutzers auf eine arithmetische Operation, insbesondere eine Division oder eine Differenz, zwischen den Sensormesswerten zweier Sensorstränge zurückführen (Anspruch 3). Denkbar ist auch, dass die Längsposition des Benutzers auf die Unterschiede der Phasenverschiebungen zwischen Spannung und Strom in den Sensormesswerten zurückgeht, insbesondere, sofern es sich bei den Sensorsträngen jeweils um kapazitive, mit einer Wechselspannung beaufschlagte Sensorelemente handelt (Anspruch 4).

Die Modifikation der Bedienereignisüberwachung gemäß der vorschlagsgemäßen Lehre lässt sich auf vielfältige Weise umsetzen. Vorschlagsgemäß wird das der Bedienereignisüberwachung zugrundeliegende Bedienereignismodell in Abhängigkeit von der ermittelten Längsposition des Benutzers modifiziert.

Vorzugsweise ist die Ausgestaltung der oben genannten Sensorstränge derart, dass mittels der Steuerung die Längsposition des Benutzers als Funktion aus den Sensormesswerten der mindestens zwei Sensorstränge ermittelbar ist. Hier kann, wie oben erläutert, auf eine ein-eindeutige Zuordnung je nach Anwendungsfall verzichtet werden.

Vorzugsweise ist es so, dass die Sensorkonfiguration eines Sensorstrangs auf seine Geometrie, seine Lage, seine Materialzusammensetzung oder dgl. zurückgeht. Letztlich umfasst die Sensorkonfiguration jeden Parameter, der einen Einfluss auf die Sensormesswerte des Sensorstrangs ausübt.

In einer bevorzugten Ausgestaltung wird die Veränderung der Sensorkonfiguration durch eine Veränderung der Geometrie der Messelektrode, insbesondere durch eine Veränderung der wirksamen Fläche der Messelektrode, erreicht. Dies ist eine fertigungstechnisch leicht umsetzbare Variante. Zusätzlich oder alternativ ist es denkbar, dass die Veränderung der Sensorkonfiguration auf eine entsprechende Veränderung der Materialzusammensetzung der Messelektrode, insbesondere durch einen entsprechenden Belag der Messelektrode, bewerkstelligt wird. Hiermit lässt sich eine gezielte Veränderung der Sensorkonfiguration erreichen, selbst wenn die Geometrie wegen baulicher Randbedingungen unverändert bleiben muß.

Im Folgenden wird die Erfindung anhand einer lediglich Ausführungsbeispiele darstellenden Zeichnung näher erläutert. In der Zeichnung zeigt
- Fig. 1: a) den Heckbereich eines Kraftfahrzeugs mit einer Verschlusselementanordnung zur Durchführung des vorschlagsgemäßen Verfahrens in einer Seitenansicht und b) diesen Heckbereich in einer Draufsicht,
- Fig. 2: eine Sequenz eines vorschlagsgemäßen, zu erfassenden Bedienereignisses in den fünf Stufen a) bis e),
- Fig. 3: in ganz schematischer Darstellung einen Ausschnitt aus der Heckschürze des Heckbereichs gemäß Fig. 1 in einer stirnseitigen Ansicht in einer ersten Ausführungsform,
- Fig. 4: in ganz schematischer Darstellung einen Ausschnitt aus der Heckschürze des Heckbereichs gemäß Fig. 1 in einer stirnseitigen Ansicht in einer zweiten Ausführungsform, und
- Fig. 5: in ganz schematischer Darstellung einen Ausschnitt aus der Heckschürze des Heckbereichs gemäß Fig. 1 in einer stirnseitigen Ansicht in einer dritten Ausführungsform.

Das vorschlagsgemäße Verfahren wird im Folgenden anhand einer Verschlusselementanordnung 1 eines Kraftfahrzeugs erläutert, die ein als Heckklappe ausgestaltetes Verschlusselement 2 aufweist. Die Ausgestaltung des Verschlusselements 2 als Heckklappe eines Kraftfahrzeugs ist vorliegend bevorzugt. Allerdings darf im Hinblick auf das weite Verständnis des Begriffs "Verschlusselement" auf den einleitenden Teil der Beschreibung verwiesen werden. Insoweit gelten alle Ausführungen zu einer Heckklappe 2 entsprechend für alle anderen Arten von Verschlusselementen.

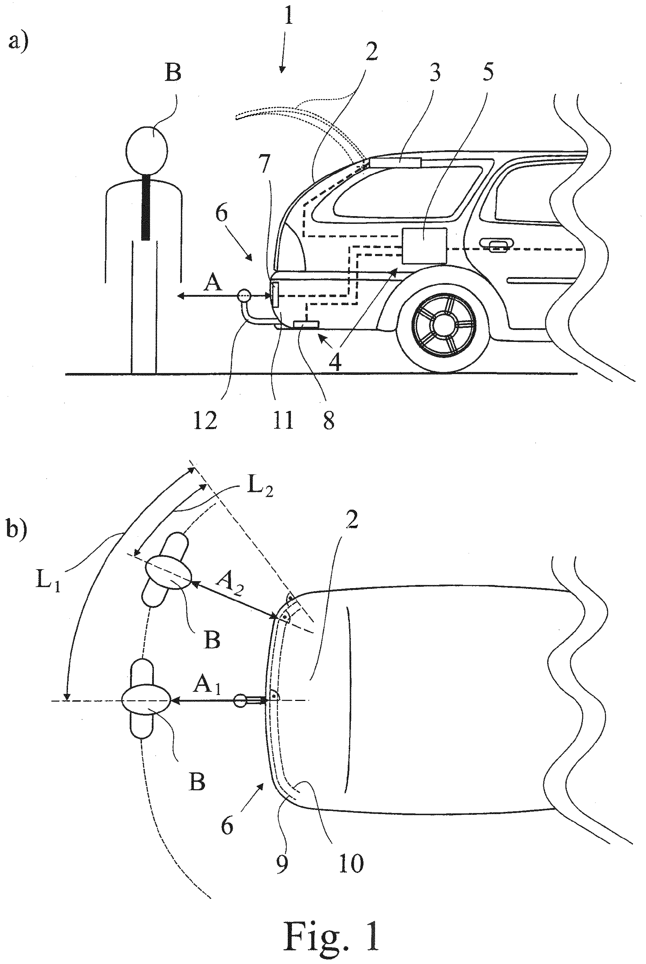

Der Heckklappe 2 ist eine Antriebsanordnung 3 zugeordnet, mittels der hier und vorzugsweise eine motorische Verstellung der Heckklappe 2 zwischen der in Fig. 1 in durchgezogener Linie dargestellten Schließstellung und der in Fig. 1 in gestrichelter Linie dargestellten Offenstellung bewirkbar ist. Grundsätzlich ist es aber auch denkbar, dass die Antriebsanordnung 3 Bestandteil eines der Heckklappe 2 zugeordneten Kraftfahrzeugschlosses ist und dass eine entsprechende Ansteuerung der Antriebsanordnung 3 das Öffnen des Kraftfahrzeugschlosses und ggf. eine federgetriebene Verstellung der Heckklappe 2 auslöst. Insoweit ist der Begriff "Antriebsanordnung" vorliegend weit auszulegen.

Es ist ferner ein Steuersystem 4 mit einer Steuerung 5 und einer Sensoranordnung 6 vorgesehen. Die Sensoranordnung 6 weist mindestens einen länglichen Abstandssensor 7, 8, hier und vorzugweise zwei längliche Abstandssensoren 7, 8 (Fig. 1a)), jeweils mit einer Sensorerstreckung 9, 10 (Fig. 1b)) auf. Die Abstandssensoren 7, 8 verlaufen im Wesentlichen nebeneinander, jedoch beabstandet zueinander. Mittels der Abstandssensoren 7, 8 lässt sich jeweils quer zur Sensorerstreckung 9, 10 ein Abstand A zu einem Benutzer B erfassen, der sich entlang der jeweiligen Sensorerstreckung 9, 10 an einer Längsposition L befindet.

Die vorliegende Bedeutung der Begriffe "Sensorerstreckung", "Abstand A" und "Längsposition L" werden im Folgenden mit Bezug auf die Darstellung gemäß Fig. 1b) erläutert. Den Abständen A₁ und A₂ ist zu entnehmen, dass die Abstände quer zu dem für den Benutzer B aktuell relevanten Abschnitt der Sensorerstreckung 9 des Abstandsensors 7 erfasst werden. Dies trägt dem Umstand Rechnung, dass die hier in Rede stehenden Abstandssensoren 7, 8, bei denen es sich vorzugsweise um kapazitive Abstandssensoren handelt, den Abstand in erster Linie senkrecht zu ihrer jeweiligen Sensorerstreckung 9, 10 erfassen. Entsprechend ändert sich die Richtung der Abstandserfassung je nach Geometrie der Abstandssensoren 7, 8 mit der Längsposition L des Benutzers B.

Bei der Längsposition L handelt es sich um die Position des Benutzers B entlang der jeweiligen Sensorerstreckung 9, 10. Dabei ist zu berücksichtigen, dass der Benutzer B eine Längsposition L in unterschiedlichen Abständen von dem jeweiligen Abstandssensor 7, 8 einnehmen kann.

Bestimmte Benutzerbewegungen sind hier als Bedienereignisse definiert, die jeweils eine bestimmte Reaktion der Steuerung 5 und damit der Antriebsanordnung 3 auslösen sollen. Vorzugsweise handelt es sich bei dem Bedienereignis um eine noch zu erläuternde Fußbewegung des Benutzers.

Um auf das Vorliegen von Bedienereignissen wie oben angesprochen reagieren zu können, ist eine Bedienereignisüberwachung vorgesehen, die von der Steuerung 5 durchgeführt wird. Im Rahmen der Bedienereignisüberwachung werden mittels der Steuerung 5 die Sensormesswerte der Abstandssensoren 7, 8 daraufhin überwacht, ob ein vorbestimmtes Bedienereignis vorliegt oder nicht. In Abhängigkeit vom Ergebnis der Bedienereignisüberwachung wird eine entsprechende Ansteuerung der Antriebsanordnung 3, beispielsweise das motorische Öffnen der Heckklappe 2, vorgenommen.

Vorzugsweise sind mindestens zwei, hier und vorzugsweise genau zwei, längliche, im Wesentlichen nebeneinander verlaufende Sensorstränge 7a, 7b des mindestens einen Abstandssensors 7 vorgesehen. Der Begriff "im Wesentlichen nebeneinander verlaufend" ist vorliegend weit zu verstehen. Insbesondere ist damit nicht notwendigerweise eine parallele Ausrichtung der beiden Sensorstränge 7a, 7b aufeinander gemeint.

Die beiden Sensorstränge 7a, 7b sind jeweils für sich auf die Erfassung eines Abstands A zu einem Benutzer B ausgelegt. Streng genommen handelt es sich bei den Sensorsträngen 7a, 7b jeweils für sich genommen um einen Abstandssensor im obigen Sinne. Die Erfassung von der Bedienereignisüberwachung zugrundeliegenden Abständen kann beispielweise auf die Addition der Sensormesswerte der beiden Sensorstränge 7a, 7b zurückgehen.

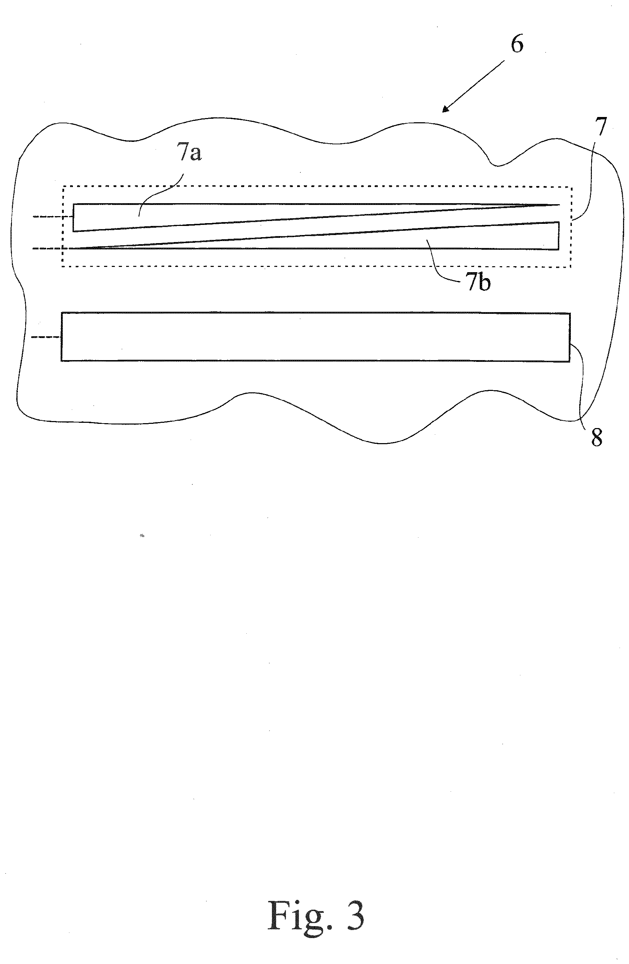

Vorzugsweise ist es so, dass die Sensorstränge 7a, 7b entlang der Sensorerstreckung 9 sich verändernde Sensorkonfigurationen aufweisen. Dies lässt sich am einfachsten der Darstellung gemäß Fig. 3 entnehmen, in der sich die wirksame Fläche der Sensorstränge 7a, 7b entlang der Sensorerstreckung 9 verändert. Eine ausführliche Erläuterung der Veränderung der Sensorkonfigurationen wird weiter unten gegeben.

Wesentlich ist nun weiter, dass mittels der Steuerung 5 die Längsposition L des Benutzers B als Funktion aus den Sensormesswerten der mindestens zwei Sensorstränge 7a, 7b, hier der genau zwei Sensorstränge 7a, 7b, ermittelt wird. Interessant dabei ist die Tatsache, dass diese Ermittlung der Längsposition L des Benutzers B weitgehend unabhängig von dem jeweils aktuellen Abstand des Benutzers B zum Abstandssensor 7 ist.

Die Längsposition L des Benutzers B kann auf ganz unterschiedliche Weise genutzt werden. Vorschlagsgemäß ist es vorgesehen, dass die Bedienereignisüberwachung in Abhängigkeit von der Längsposition L des Benutzers B modifiziert wird. Damit lässt sich die Bedienereignisüberwachung optimal auf die an der jeweiligen Längsposition L gegebenen Bedingungen anpassen.

Es darf darauf hingewiesen werden, dass es nach der vorschlagsgemäßen Lehre nicht darauf ankommt, auf welche Weise die Längsposition L des Benutzers B ermittelt worden ist. Denkbar ist hier grundsätzlich der Einsatz eines zusätzlichen Sensors.

Je nach Umsetzung der entlang der Sensorerstreckung 7 vorgesehenen Veränderung der Sensorkonfigurationen kann die Ermittlung der Längsposition L des Benutzers B auf unterschiedliche Weise erfolgen. In besonders bevorzugter Ausgestaltung geht die Ermittlung der Längsposition L des Benutzers B auf eine Division der Sensormesswerte zweier Sensorstränge 7a, 7b zurück. Alternativ kann es vorgesehen sein, dass die Ermittlung der Längsposition L des Benutzers B auf die Differenz der Sensormesswerte der beiden Sensorstränge 7a, 7b zurückgeht. Vorzugsweise hat die obige Division oder die obige Differenz den Effekt, dass der Abstand A des Benutzers B zum Abstandssensor 7 nur noch einen vernachlässigbaren Einfluss auf die ermittelte Längsposition L hat.

Eine andere bevorzugte Variante sieht vor, dass die Ermittlung der Längsposition L des Benutzers B auf den Unterschied der Phasenverschiebungen zwischen Spannung und Strom in den Sensormesswerten zweier Sensorstränge 7a, 7b zurückgeht. Dies lässt sich beispielsweise auf die Tatsache zurückführen, dass der ohmsche Widerstand zwischen einem hier seitlichen Anschluß und einem der Längsposition des Benutzers B zugeordneten Längsabschnitt der Sensorstränge 7a, 7b von der Entfernung zwischen dem Anschluß und dem Längsabschnitt abhängt. Zusätzlich lässt sich die Phasenverschiebung durch eine geeignete Materialwahl für die Sensorstränge 7a, 7b gezielt beeinflussen. Beispielweise kann es vorteilhaft sein, an Stellen hoher gewünschter Meßauflösung, insbesondere im mittleren Bereich des Kraftfahrzeugs, für die Sensorstränge 7a, 7b ein Material mit einem höheren elektrischen Widerstand einzusetzen. Denkbar ist schließlich, dass die Sensorstränge 7a, 7b entlang ihrer Sensorerstreckung 9 mit unterschiedlichen Beschichtungen versehen sind, die ebenfalls eine gezielte Veränderung der Phasenverschiebung beim Betrieb des Sensorstrangs 7a, 7b als kapazitiver Sensor bewirken können.

Für die oben angesprochene Modifikation der Bedienereignisüberwachung sind zahlreiche Varianten denkbar. Bei der vorschlagsgemäßen Modifikation wird davon ausgegangen, dass einem Bedienereignis ein Bedienereignismodell aus Signal-Kennwerten zugeordnet ist, wobei im Rahmen der Bedienereignisüberwachung mittels der Steuerung 5 überwacht wird, ob die Sensormesswerte zu den Signal-Kennwerten des Bedienereignismodells korrespondieren. Ein solches Bedienereignismodell repräsentiert gewissermaßen die Form bzw. den Verlauf der Sensormesswerte während eines Bedienereignisses. Es wird nun vorgeschlagen, dass das Bedienereignismodell in Abhängigkeit von der Längsposition L des Benutzers B erzeugt oder in Abhängigkeit von der Längsposition L des Benutzers B aus einer Anzahl gespeicherter Bedienereignismodelle ausgewählt oder in Abhängigkeit von der Längsposition L des Benutzers B parametriert wird.

Im einfachsten Fall ist einem Bedienereignis ein Bedienereignis-Kennwertsatz aus Signal-Kennwerten zugeordnet, die wiederum im Rahmen der Bedienereignisüberwachung mit den Sensormesswerten abgeglichen werden. Bei dem Bedienereignis-Kennwertsatz handelt es sich um eine einfache Form eines Bedienereignismodells. Vorschlagsgemäß wird entsprechend eine Modifikation des Bedienereignis-Kennwertsatzes in Abhängigkeit von der Längsposition L des Benutzers B vorgeschlagen.

Die Modifikation der Bedienereignisüberwachung kann in einer weiteren bevorzugten Ausführungsform das Signalverarbeitungsverfahren betreffen, auf dem die Ermittlung der Sensormesswerte mittels der Steuerung 5 basiert. Dabei ist es vorgesehen, dass das Signalverarbeitungsverfahren durch einen Signalverarbeitungs-Parametersatz mit Signalverarbeitungs-Parametern wie Mindest-Signalpegel, zeitlicher Messauflösung oder Amplituden-Messauflösung definiert wird. Vorschlagsgemäß ist es vorzugsweise so, dass der Signalverarbeitungs-Parametersatz in Abhängigkeit von der Längsposition L des Benutzers B aus einer Anzahl gespeicherter Signalverarbeitungs-Parametersätze ausgewählt oder in Abhängigkeit von der Längsposition L des Benutzers B parametriert wird.

Denkbar ist auch, dass die Modifikation der Bedienereignisüberwachung die Auswertung der digitalisierten Sensormesswerte betrifft. Im Einzelnen umfasst dabei die Bedienereignisüberwachung zunächst die Digitalisierung der Sensormesswerte, wobei die anschließende Auswertung der digitalisierten Messdaten, insbesondere der Abgleich mit einem Bedienereignis-Kennwertsatz, basierend auf einem entsprechenden Auswerteverfahren durchgeführt wird. Das Auswerteverfahren wird durch einen Auswerte-Parametersatz mit Auswerte-Parametern, wie der Rechengenauigkeit oder der Art des Abgleichalgorithmus, definiert. Auch hier wird vorgeschlagen, dass der Auswerte-Parametersatz in Abhängigkeit von der Längsposition L des Benutzers B aus einer Anzahl gespeicherter Auswerte-Parametersätze ausgewählt oder in Abhängigkeit von der Längsposition L des Benutzers B parametriert wird.

Die vorschlagsgemäße Modifikation der Bedienereignisüberwachung kann grundsätzlich auch die Ansteuerung der Sensoranordnung 6 betreffen. Der Begriff "Ansteuerung" ist dabei weit zu verstehen und betrifft alle steuerungstechnischen Maßnahmen, die zur Ermittlung der Sensormesswerte führen. Im Einzelnen wird dabei vorgeschlagen, dass im Rahmen der Bedienereignisüberwachung die Sensoranordnung 6 mittels der Steuerung 5 in Abhängigkeit von der Längsposition L des Benutzers B angesteuert wird.

Grundsätzlich kann es aber auch ganz allgemein vorgesehen sein, dass die Modifikation der Bedienereignisüberwachung auf die Modifikation einer sogenannten "Plausibilisierung" erfolgt. Eine solche Plausibilisierung umfasst vorbestimmte Bedingungen, deren Eintreten für oder gegen das Vorliegen eines Bedienereignisses sprechen. Denkbar wäre hier, dass in Abhängigkeit von der Längsposition L des Benutzers B unterschiedliche Plausibilitätsbedingungen zur Anwendung kommen.

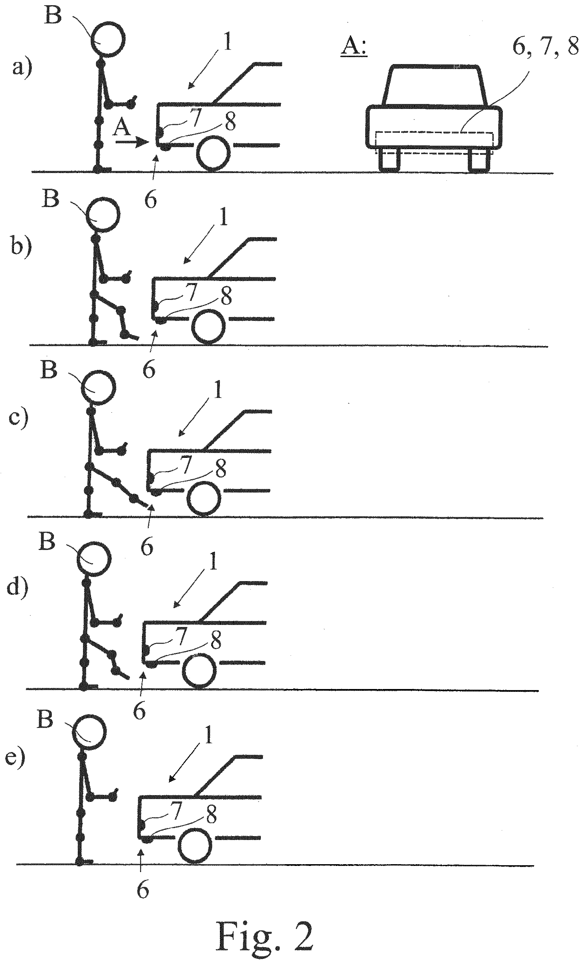

Gemäß Fig. 2 ist mindestens ein Bedienereignis als Fußbewegung des Benutzers B definiert. Dabei ist mindestens ein Abstandssensor 7, 8 in oder an einem hinteren Verkleidungsteil 11, hier und vorzugsweise am hinteren Stoßfänger 11, des Kraftfahrzeugs angeordnet. Der mindestens eine Abstandssensor 7, 8 erstreckt sich vorzugsweise über einen wesentlichen Teil der Breite des Kraftfahrzeugs, wie der Darstellung gemäß Fig. 2a) zu entnehmen ist.

Im Einzelnen ist es vorzugsweise so, dass mindestens ein Bedienereignis als eine Hin- und Rückbewegung des Fußes des Benutzers definiert ist. Fig. 2 zeigt in den Abbildungen a) bis e) die Stationen der Sequenz eines solchen Bedienereignisses, das eine Hin- und Rückbewegung des Fußes des Benutzers umfasst. Eine solche Fußbewegung erzeugt in den Sensormesswerten der Abstandssensoren 7, 8 vorzugsweise einen impulsartigen zeitlichen Verlauf, der im Rahmen der Bedienereignisüberwachung ausgewertet wird.

Vorteilhaft für das vorschlagsgemäße Steuersystem ist die Realisierung der oben angesprochenen beiden länglichen, im Wesentlichen nebeneinander verlaufenden Sensorstränge 7a, 7b des mindestens einen Abstandssensors 7, 8, die jeweils für sich auf die Erfassung eines Abstands A zu einem Benutzer B ausgelegt sind. Dabei weisen die Sensorstränge 7, 8 entlang der Sensorerstreckung 9, 10 sich verändernde Sensorkonfigurationen auf derart, dass mittels der Steuerung 5 die Längsposition L des Benutzers B als Funktion aus den Sensormesswerten der mindestens zwei Sensorstränge 7a, 7b ermittelbar ist. Es kommt also auf eine ganz bestimmte, sich entlang der Sensorerstreckung 9 verändernde Sensorkonfiguration an, die eine Ermittlung der Längsposition L des Benutzers B erlaubt.

In besonders bevorzugter Ausgestaltung ist es sogar so, dass mittels der Steuerung 5 die aktuelle Längsposition L des Benutzers B als Funktion ausschließlich aus den aktuellen Sensormesswerten der mindestens zwei Sensorstränge 7a, 7b ermittelbar ist. Entsprechend ist für die Ermittlung der Längsposition L des Benutzers B ausschließlich die Messung eines einzigen Messwertpaars erforderlich.

Grundsätzlich kann es vorgesehen sein, dass die Veränderung der Sensorkonfiguration entlang der Sensorerstreckung 9 so getroffen ist, dass die Längsposition L des Benutzers B als Funktion aus den Sensormesswerten von den Sensorsträngen 7a, 7b kontinuierlich entlang der Sensorerstreckung ermittelbar ist. Damit ist eine exakte Bestimmung der Längsposition L des Benutzers B über die gesamte Sensorerstreckung 9 möglich. Entsprechend wird eine entsprechend kontinuierliche Veränderung der Sensorkonfiguration erforderlich sein.

Alternativ kann es aber auch vorgesehen sein, dass die Veränderung der Sensorkonfiguration entlang der Sensorerstreckung 9 so getroffen ist, dass die Längsposition L des Benutzers B als Funktion aus den Sensormesswerten von zumindest zwei Sensorsträngen 7a, 7b mindestens zwei unterschiedlichen Längsabschnitten entlang der Sensorerstreckung 9 zuordenbar ist. Dies bedeutet, dass die Veränderung der Sensorkonfiguration entlang der Sensorerstreckung 9 ebenfalls nur in Abschnitten erforderlich ist. Dies kann vorteilhaft sein, wenn sich in einem Längsabschnitt des Abstandssensors 7 eine Anbaukomponente, vorzugsweise eine Anhängerkupplung 12, befindet bzw. dort montierbar ist. Damit kann auf die Lage des Benutzers B in der Längsposition der Anhängerkupplung 12 wie oben angesprochen steuerungstechnisch reagiert werden.

Drei bevorzugte Varianten für eine Sensoranordnung 6 mit zwei Abstandssensoren 7, 8 zeigen die Fig. 3, 4 und 5. Bei allen dargestellten Ausführungsformen handelt es sich bei den Abstandssensoren 7, 8 sowie bei den entsprechenden Sensorsträngen 7a, 7b um kapazitive Sensoren, die mindestens eine längliche Messelektrode aufweisen, hier sogar lediglich aus einer solchen Messelektrode bestehen.

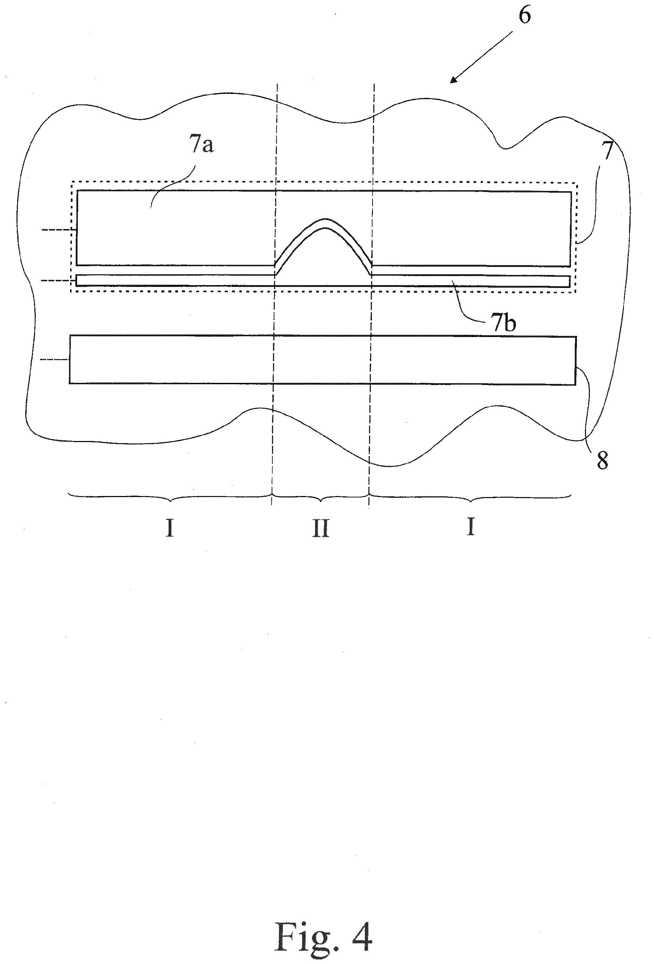

Die Messelektroden bestehen wiederum aus mindestens einem, in den Fig. 3 und 4 aus genau einem elektrischen Leiter. Bei den in den Fig. 3 und 4 dargestellten Ausführungsbeispielen weist ein erster Sensorstrang 7a eine erste Messelektrode und ein zweiter Sensorstrang 7b entsprechend eine zweite Messelektrode auf. Die Abstandssensoren 7, 8 und die Sensorstränge 7a, 7b sind wie oben angesprochen als Messelektroden ausgestaltet und endseitig mit der Steuerung 5 verbunden. Dies ist in den Fig. 3 bis 5 in gestrichelter Linie angedeutet. Grundsätzlich kann der Anschluss der Messelektroden auch beidseitig vorgesehen sein.

Es wurde schon darauf hingewiesen, dass die Sensorkonfiguration alle Parameter umfasst, die sich in irgendeiner Weise auf die Sensormesswerte auswirken können. Entsprechend geht die Sensorkonfiguration eines Sensorstrangs 7a, 7b beispielsweise auf seine Geometrie, seine Lage, seine Materialzusammensetzung oder dgl. zurück.

Bei dem Ausführungsbeispiel der Sensorstränge 7a, 7b, die kapazitive Sensoren bereitstellen, lässt sich die Veränderung der Sensorkonfiguration besonders einfach durch eine Veränderung der Geometrie der Messelektrode entlang der Sensorerstreckung 9 erreichen. Dabei ist es vorzugsweise so, dass sich die wirksame Fläche der Messelektrode, hier und vorzugsweise kontinuierlich, entlang der Sensorerstreckung 9 verändert. Dies lässt sich am besten der Darstellung gemäß Fig. 3 entnehmen. Der Begriff "wirksame Fläche" umfasst ausschließlich die Flächen, denen eine kapazitive Wirkung im Rahmen des kapazitiven Abstandssensors zukommt. Flächen, die bei der kapazitiven Abstandserfassung keinen Beitrag leisten, sind hiervon nicht umfasst.

Die wirksame Fläche des Sensorstrangs 7a reduziert sich kontinuierlich von einem Ende zum anderen Ende des Sensorstrangs 7a. Die wirksame Fläche des anderen Sensorstrangs 7b verändert sich ebenfalls kontinuierlich, allerdings gegenläufig zu der Veränderung der wirksamen Fläche des zuvor genannten Sensorstrangs 7a. Eine andere bevorzugte Variante zur Veränderung der Sensorkonfiguration entlang der Sensorerstreckung 9 geht auf eine entsprechende Veränderung der Materialzusammensetzung der jeweiligen Messelektrode entlang der Sensorerstreckung 9 zurück. In besonders bevorzugter Ausgestaltung verändert sich ein Belag, insbesondere ein leitender Belag mit ohmschem Widerstand, insbesondere kontinuierlich, entlang der Sensorerstreckung 9. Beim Anlegen einer Wechselspannung ergibt sich damit ein Realteil des resultierenden komplexen Widerstands, der von der Längsposition L des Benutzers B abhängt. Dies kann beim Betrieb der Sensorstränge 7a, 7b als kapazitive Sensoren ausgenutzt werden, um aus den Unterschieden in der Phasenverschiebung zwischen Spannung und Strom einen Rückschluss auf die Längsposition L des Benutzers B ziehen zu können.

Interessant ist noch die weiter bevorzugte Ausführungsform gemäß Fig. 4, mit der sich ermitteln lässt, ob sich der Benutzer im Bereich II, oder im Bereich I befindet. Fig. 4 zeigt, dass sich die Sensorkonfiguration ausschließlich im Bereich II verändert, so dass mit dem vorschlagsgemäßen Verfahren zwischen dem in Fig. 4 linken Teil von Bereich I und dem in Fig. 4 rechten Teil von Bereich I nicht unterschieden werden kann. Diese Unterscheidung ist vorliegend aber auch nicht erforderlich, da es ja lediglich darauf ankommt zu ermitteln, ob sich der Benutzer B in der Längsposition L der Anhängerkupplung 12, also im Bereich II, befindet. Die Veränderung der Sensorkonfiguration ist auch hier über eine Veränderung der wirksamen Fläche der Sensorstränge 7a, 7b erreicht worden.

Hier und vorzugsweise ist es so, dass sich die Sensorstränge 7a, 7b jeweils über die gesamte Sensorerstreckung 9 erstrecken. Grundsätzlich kann es aber auch vorgesehen sein, dass die Sensorstränge 7a, 7b nur einen Teil der gesamten Sensorerstreckung 9 abdecken.

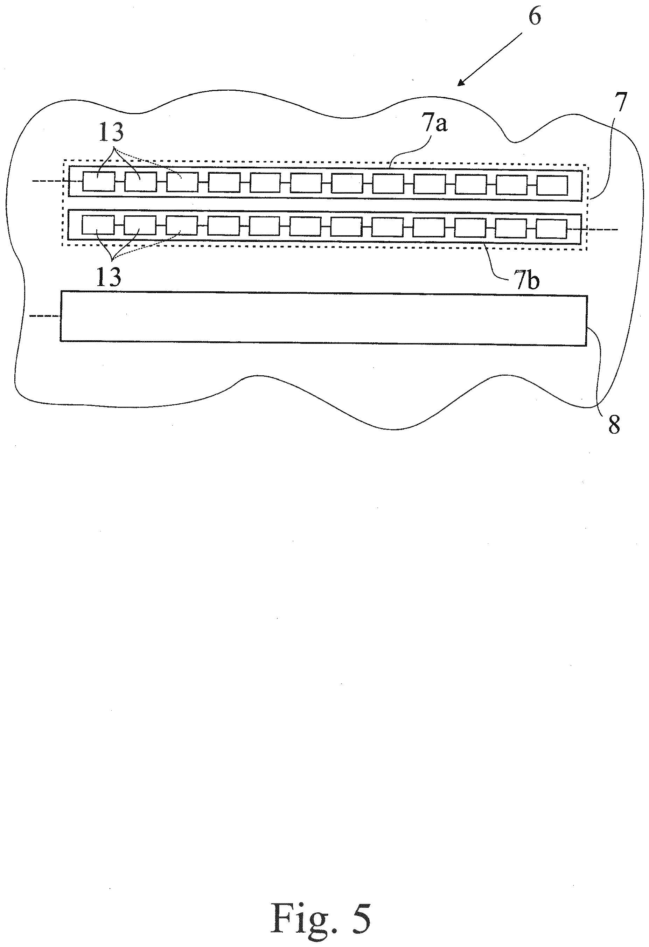

Fig. 5 zeigt, dass die Sensorstränge 7a, 7b mehrere Strangabschnitte 13 aufweisen, die hier und vorzugsweise elektrisch hintereinander geschaltet sind. Die einzelnen Strangabschnitte 13 sind einfach durch einen elektrischen Leiter verbunden. Denkbar ist beispielsweise, dass die einzelnen Strangabschnitte 13 unterschiedliche wirksame Flächen aufweisen. Hier und vorzugsweise ist es allerdings so, dass die einzelnen Strangabschnitte 13 in obiger Weise unterschiedlich mit einem Widerstandsmaterial beschichtet sind.

Bei den dargestellten und insoweit bevorzugten Ausführungsbeispielen sind die beiden Sensorstränge 7a, 7b einem einzigen Abstandssensor 7, in der Zeichnung dem jeweils oberen Abstandssensor 7, zugeordnet. Entsprechend ist es stets so, dass einer der beiden Abstandssensoren 7, 8 die beiden Sensorstränge 7a, 7b aufweist. Alternativ kann es aber auch vorgesehen sein, dass der eine Abstandssensor 7 den einen Sensorstrang 7a und der andere Abstandssensor 8 den anderen Sensorstrang 7b aufweist. Je nach Anwendungsfall können andere Sensorstrukturen vorgesehen sein.

In besonders bevorzugter Ausgestaltung ist es so, dass die sich entlang der Sensorerstreckung 9 verändernde Sensorkonfiguration des jeweiligen Sensorstrangs 7a, 7b zu einem sich entlang der Sensorerstreckung 9 verändernden Sensitivitätsverlauf des jeweiligen Sensorstrangs 7a, 7b führt. Der Begriff "Sensitivität" ist hier in einem erweiternden Sinne derart zu verstehen, dass eine Änderung der Sensitivität bei identischem Abstand A zu dem Benutzer B stets eine entsprechende Änderung des Sensormesswerts mit sich bringt. Der Begriff "Sensitivitätsverlauf" bedeutet weiter, dass sich die Sensitivität in obigem Sinne jedenfalls an einer Stelle entlang der Sensorerstreckung 9 ändert. Grundsätzlich kann die Sensitivität also zumindest stellenweise konstant, oder sogar null sein. Im letztgenannten Fall reagiert der Abstandssensor 7, 8 bzw. der jeweilige Sensorstrang 7a, 7b auf die Annäherung eines Benutzers B nicht.

Es darf schließlich darauf hingewiesen werden, dass die vorschlagsgemäße Lehre nicht auf den Anwendungsbereich eines Kraftfahrzeugs beschränkt ist. Vielmehr sind zahlreiche andere Anwendungsbereiche denkbar, beispielweise der Anwendungsbereich der Hausautomatisierung.

## Patentansprüche

1. Verfahren zur Ansteuerung einer Verschlusselementanordnung (1) insbesondere eines Kraftfahrzeugs, wobei die Verschlusselementanordnung (1) ein Verschlusselement (2), eine dem Verschlusselement (2) zugeordnete Antriebsanordnung (3) und ein Steuersystem (4) mit einer Steuerung (5) und einer Sensoranordnung (6) aufweist, wobei die Sensoranordnung (6) mindestens einen länglichen Abstandssensor (7,8) mit einer Sensorerstreckung (9,10) aufweist, wobei mittels des Abstandssensors (7,8) quer zur Sensorerstreckung (9,10) ein Abstand A zu einem Benutzer B erfassbar ist, der sich entlang der Sensorerstreckung (9,10) an einer Längsposition L befindet, wobei mittels der Steuerung (5) im Rahmen einer Bedienereignisüberwachung die Sensormesswerte des mindestens einen Abstandssensors (7,8) daraufhin überwacht werden, ob ein vorbestimmtes Bedienereignis vorliegt, und in Abhängigkeit vom Ergebnis der Bedienereignisüberwachung eine Ansteuerung der Antriebsanordnung (3) vorgenommen wird,
**dadurch gekennzeichnet,**
**dass** mittels der Steuerung (5) die Längsposition L des Benutzers B ermittelt wird und dass die Bedienereignisüberwachung in Abhängigkeit von der Längsposition L des Benutzers B modifiziert wird und dass einem Bedienereignis ein Bedienereignismodell aus Signal-Kennwerten zugeordnet ist, dass im Rahmen der Bedienereignisüberwachung mittels der Steuerung (5) überwacht wird, ob die Sensormesswerte zu den Signal-Kennwerten des Bedienereignismodells korrespondieren und dass das Bedienereignismodell in Abhängigkeit von der Längsposition L des Benutzers B erzeugt oder in Abhängigkeit von der Längsposition L des Benutzers B aus einer Anzahl gespeicherter Bedienereignismodelle ausgewählt oder in Abhängigkeit von der Längsposition L des Benutzers B parametariert wird.

2. Verfahren nach Anspruch 1, **dadurch gekennzeichnet, dass** mindestens zwei längliche, im Wesentlichen nebeneinander verlaufende Sensorstränge (7a,7b) des mindestens einen Abstandssensors (7) vorgesehen sind, die jeweils für sich auf die Erfassung eines Abstands A zu einem Benutzer B ausgelegt sind, dass die Sensorstränge (7a,7b) entlang der Sensorerstreckung (9) sich verändernde Sensorkonfigurationen aufweisen und dass mittels der Steuerung (5) die Längsposition L des Benutzers B als Funktion aus den Sensormesswerten der mindestens zwei Sensorstränge (7a,7b) ermittelt wird.

3. Verfahren nach Anspruch 1 oder 2, **dadurch gekennzeichnet, dass** die Ermittelung der Längsposition L des Benutzers B auf eine arithmetische Operation zwischen den Sensormesswerten zweier Sensorstränge (7a, 7b) zurückgeht, vorzugsweise, dass die Ermittlung der Längsposition L des Benutzers B auf eine Division der Sensormesswerte zweier Sensorstränge (7a,7b) zurückgeht, oder, dass die Ermittlung der Längsposition L des Benutzers B auf die Differenz der Sensormesswerte zweier Sensorstränge (7a,7b) zurückgeht.

4. Verfahren nach einem der vorhergehenden Ansprüche, **dadurch gekennzeichnet, dass** die Ermittlung der Längsposition L des Benutzers B auf den Unterschied der Phasenverschiebungen zwischen Spannung und Strom in den Sensormesswerten zweier Sensorstränge (7a,7b) zurückgeht.

5. Verfahren nach einem der vorhergehenden Ansprüche, **dadurch gekennzeichnet, dass** mindestens ein Bedienereignis als Fußbewegung des Benutzers definiert ist, vorzugsweise, dass der mindestens eine Abstandssensor (7,8) in oder an einem hinteren Verkleidungsteil (11), insbesondere dem hinteren Stoßfänger, eines Kraftfahrzeugs angeordnet ist und sich vorzugsweise über einen wesentlichen Teil der Breite des Kraftfahrzeugs erstreckt, vorzugsweise, dass mindestens ein Bedienereignis als eine Hin- und Rückbewegung des Fußes des Benutzers definiert ist, vorzugsweise, dass während des Bedienereignisses der mindestens eine Abstandssensor (7,8) einen impulsartigen zeitlichen Verlauf der Sensormesswerte erzeugt.

## Claims

1. Method for actuating a closure element arrangement (1), in particular of a motor vehicle, wherein the closure element arrangement (1) has a closure element (2), a drive arrangement (3) assigned to the closure element (2), and a control system (4) having a controller (5) and a sensor arrangement (6), wherein the sensor arrangement (6) has at least one elongate distance sensor (7, 8) with a sensor extent (9, 10), wherein a distance A from a user B can be detected transversely with respect to the sensor extent (9, 10) by means of the distance sensor (7, 8), which user B is located at a longitudinal position L along the sensor extent (9, 10), wherein the sensor measured values of the at least one distance sensor (7, 8) are monitored by means of the controller (5) within the scope of an operator control event monitoring operation, to determine whether a predetermined operator control event occurs, and the drive arrangement (3) is actuated as a function of the result of the operator control event monitoring operation
**characterized**
**in that** the longitudinal position L of the user B is determined by means of the controller (5), and in that the operator control event monitoring operation is modified as a function of the longitudinal position L of the user B, and in that an operator control event model composed of signal characteristic values is assigned to an operator control event, in that within the scope of the operator control event monitoring operation by means of the controller (5) it is monitored whether the sensor measured values correspond to the signal characteristic values of the operator control event model, and in that the operator control event model is generated as a function of the longitudinal position L of the user B, or selected as a function of the longitudinal position L of the user B from a number of stored operator control event models, or is parameterized as a function of the longitudinal position L of the user B.

2. Method according to Claim 1, **characterized in that** at least two elongate sensor sections (7a, 7b), running essentially one next to the other, of the at least one distance sensor (7) are provided, which sensor sections (7a, 7b) are each configured to detect a distance A from a user B, **in that** the sensor sections (7a, 7b) have changing sensor configurations along the sensor extent (9), and **in that** the longitudinal position L of the user B is determined as a function of the sensor measured values of the at least two sensor sections (7a, 7b) by means of the controller (5).

3. Method according to Claim 1 or 2, **characterised in that** the determination of the longitudinal position L of the user B is based on an arithmetic operation between the sensor measured values of two sensor sections (7a, 7b), preferably **in that** the determination of the longitudinal position L of the user B is based on a division of the sensor measured values of two sensor sections (7a, 7b), or **in that** the determination of the longitudinal position L of the user B is based on the difference between the sensor measured values of two sensor sections (7a, 7b).

4. Method according to one of the preceding claims, **characterized in that** the determination of the longitudinal position L of the user B is based on the difference between the phase shifts between the voltage and the current in the sensor measured values of two sensor sections (7a, 7b).

5. Method according to one of the preceding claims, **characterised in that** at least one operator control event is defined as a foot movement of the user, preferably **in that** the at least one distance sensor (7, 8) is arranged in or on a rear cover part (11), in particular the rear bumper, of a motor vehicle and preferably extends over a substantial part of the width of the motor vehicle, preferably **in that** at least one operator control event is defined as a to and fro movement of the user's foot, preferably **in that** during the operator control event the at least one distance sensor (7, 8) generates a pulse-like time profile of the sensor measured values.

## Revendications

1. Procédé de commandé d'un arrangement d'éléments de fermeture (1), notamment d'un véhicule automobile, l'arrangement d'éléments de fermeture (1) possédant un élément de fermeture (2), un arrangement d'entraînement (3) associé à l'élément de fermeture (2) et un système de commande (4) comprenait une commande (5) et un arrangement de capteurs (6), l'arrangement de capteurs (6) possédant au moins un capteur de distance (7, 8) allongé ayant une prolongation de capteur (9, 10), une distance A par rapport à un utilisateur B, lequel se trouve à une position longitudinal L le long de la prolongation de capteur (9, 10), pouvant être détectée au moyen du capteur de distance (7, 8) transversalement à la prolongation de capteur (9, 10), les valeurs mesurées du courant de l'au moins un capteur de distance (7, 8) étant surveillées dans le cadre d'une surveillance d'événement d'opération en vue de déterminer la présence d'un événement d'opération prédéfini, et une commande de l'arrangement d'entraînement (3) étant réalisée en fonction du résultat de la surveillance d'événement d'opération,
**caractérisé en ce que**
la position longitudinal L de l'utilisateur B est déterminée au moyen de la commande (5) et **en ce que** la surveillance d'événement d'opération est modifiée en fonction de la position longitudinal L de l'utilisateur B et **en ce qu'**un modèle d'événement d'opération constitué de valeurs caractéristiques de signal est associé à un événement d'opération, **en ce qu'**une surveillance est effectuée au moyen de la commande (5) dans le cadre de la surveillance d'événement d'opération afin de déterminer si les valeurs mesurées de capteur correspondent aux valeurs caractéristiques de signal du modèle d'événement d'opération et **en ce que** le modèle d'événement d'opération est généré en fonction de la position longitudinal L de l'utilisateur B ou sélectionné en fonction de la position longitudinal L de l'utilisateur B à partir d'une pluralité de modèles d'événement d'opération mis en mémoire ou paramétré en jonction de la position longitudinal L de l'utilisateur B.

2. Procédé selon la revendication 1, **caractérisé en ce qu'**il existe au moins deux branches de capteur (7a, 7b) de l'au moins un capteur de distance (7), qui s'étendent sensiblement l'une à côté de l'autre, lesquelles sont respectivement conçues pour la détection d'une distance A par rapport à un utilisateur B, **en ce que** les branches de capteur (7a, 7b) possèdent des configurations de capteur qui varient le long de la prolongation de capteur (9) et **en ce que** la position longitudinale L de l'utilisateur B est déterminée au moyen de la commande (5) en tant que fonction des valeurs mesurées de capteur des au moins deux branches de capteur (7a, 7b).

3. Procédé selon la revendication 1 ou 2, **caractérisé en ce que** la détermination de la position longitudinale L de l'utilisateur B émane du résultat d'une opération arithmétique entre les valeurs mesurées de capteur de deux branches de capteur (7a, 7b), **en ce que** la détermination de la position longitudinale L de l'utilisateur B émane du résultat d'une division des valeurs mesurées de capteur de deux branches de capteur (7a, 7b), ou **en ce que** la détermination de la position longitudinale L de l'utilisateur B émane du résultat de la différence des valeurs mesurées de capteur de deux branches de capteur (7a, 7b).

4. Procécé selon l'une des revendications précédentes, **caractérisé en ce que** la détermination de la position longitudinale L de l'utilisateur B émane du résultat de la différence des déphasages entre la tension et le courant dans les valeurs mesurées de capteur de deux branches de capteur (7a, 7b).

5. Procédé selon l'une des revendications précédentes, **caractérisé en ce qu'**au moins un événement d'opération est défini en tant que mouvement du pied de l'utilisateur, de préférence **en ce que** l'au moins un capteur de distance (7, 8) est disposé dans ou sur une partie d'habillage arrière (11), notamment le pare-chocs arrière, d'un véhicule automobile et s'étend de préférence sur une partie significative de la largeur du véhicule automobile, de préférence **en ce qu'**au moins un événement d'opération est défini en tant que mouvement d'aller et de retour du pied de l'utilisateur, de préférence **en ce que** pendant l'événement d'opération, l'au moins un capteur de distance (7, 8) génère un tracé dans le temps de type impulsionnel des valeurs mesurées de capteur.
